(19) Europäisches Patentamt
European Patent Office
Office européen des brevets

(11) EP 2 475 095 B1

(12) # EUROPEAN PATENT SPECIFICATION

(45) Date of publication and mention of the grant of the patent:
**18.09.2013 Bulletin 2013/38**

(51) Int Cl.:
***H03F 1/02*** *(2006.01)* ***H03F 3/60*** *(2006.01)*
***H03F 1/56*** *(2006.01)*

(21) Application number: **11360002.7**

(22) Date of filing: **07.01.2011**

(54) **Doherty amplifier**

Doherty-Verstärker

Amplificateur de Doherty

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.07.2012 Bulletin 2012/28**

(73) Proprietor: **Alcatel Lucent**
**75007 Paris (FR)**

(72) Inventor: **Wong, James N. H.**
**London W3 0HW (GB)**

(74) Representative: **Sarup, David Alexander**
**Alcatel-Lucent Telecom Ltd**
**Intellectual Property Business Group**
**Christchurch Way**
**Greenwich**
**London SE10 0AG (GB)**

(56) References cited:
**WO-A1-01/95481** **WO-A1-2009/081341**
**WO-A2-02/054589**

- **BUMMAN KIM ET AL: "Advanced Doherty Architecture", IEEE MICROWAVE MAGAZINE, IEEESERVICE CENTER, PISCATAWAY, NJ, US, vol. 11, no. 5, 1 August 2010 (2010-08-01) , pages 72-86, XP011312810, ISSN: 1527-3342**
- **ECCLESTON K W: "Analysis of a multi-transistor interleaved Doherty amplifier", MICROWAVE CONFERENCE, 2009. APMC 2009. ASIA PACIFIC, IEEE, PISCATAWAY, NJ, USA, 7 December 2009 (2009-12-07), pages 1581-1584, XP031613321, ISBN: 978-1-4244-2801-4**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 475 095 B1

## Description

FIELD OF THE INVENTION

The present invention relates to a Doherty amplifier and a method.

BACKGROUND

Doherty amplifiers are known. In most communications systems, it is required that power amplifiers used to amplify signals for transmissions are able to operate with high efficiency and high linearity simultaneously. However, there is typically a trade-off between efficiency and linearity, with improvements in one generally coming at the expense of the other. Many wireless telecommunications systems, such as a Global System for Mobile communications (GSM)/Enhanced Data rates for GSM Evolution (EDGE), Code Division Multiple Access (CDMA) or Wideband Code Division Multiple Access (WCDMA) require that the power amplifier is able to deliver a wide range of output powers.

Accordingly, the power amplifiers are typically designed to provide the highest power output level with the maximum available efficiency. These amplifiers, which may be provided in base stations, tend to operate less efficiently at lower power levels. Designing a base station power amplifier which has a high efficiency and high linearity, not only at the maximum output power but also at lower output power levels, typically ranging from-6dB and less, without using additional linearization schemes, is challenging. A Doherty power amplifier is one such power amplifier in which a main amplifier is provided in parallel with an auxiliary amplifier. The input signal is split and provided to each of the amplifiers. Both of the amplifiers then amplify the signal, which is then combined to create an output signal. When operating at the maximum power output, both amplifiers are used. However, when the total output power is typically less than 6dB from the maximum output power, the auxiliary amplifier is turned off. This arrangements provides higher efficiency compared to conventional Class AB solutions, since the main amplifier is biased in Class AB, but the auxiliary amplifier is biased in Class C and is turned off when the total output power is typically less than 6dB from the maximum output power level. Although these arrangements provide for higher efficiency at other than the maximum output power level, such parallel amplifiers exhibit undesirable characteristics.

WO 01/95481 A1 discloses a multi-stage Doherty Amplifier provided with separate drive amplifiers for individual power amplifiers and/or separate drive amplifiers for groups of power amplifiers. A quarter wave delay line is provided between outputs of each individual power amplifier.

Accordingly, it is desired to provide an improved Doherty amplifier.

SUMMARY

According to a first aspect there is provided a Doherty amplifier as claimed in claim 1.

The first aspect recognises that a problem with existing Doherty amplifier arrangements is that when auxiliary amplifiers are in a non-amplifying state (i.e. they are not being utilised to amplify the input signal, such as would occur when those amplifier modules are biased to be switched "off" and so are not operated in the amplifying region of their transfer characteristics), the impedance of the output network which receives and combines or sums the outputs from the amplifier stages and provides this to the load typically has less than optimum impedance-matching when the auxiliary amplifier stages are in the non-amplifying state. This sub-optimal impendance matching leads to a reduction in the operating efficiency of the Doherty amplifier.

Accordingly, a Doherty or parallel amplifier comprising a plurality of amplifier stages may be provided. Each amplifier stage receives typically the sa me input signal to be amplified and can operate in an amplifying or non- amplifying state in order to vary the power of the output amplified signal. A main amplifier stage may be provided which provides a main output. Further auxiliary amplifier stages maybe provided which also provide an amplified signal at their output. The output network may combine the amplified signals provided by each of the amplifier stages and may couple the different amplifier stages with a load. This combined amplified signal may then be provided to the load. The output network may comprise summing junctions and both a half wavelength delay line and a quarter wavelength impedance transformer. The impedance transformer may transform the impedance presented by the load at the second summing junction. This, combined with the arrangement of the half wavelength delay line which causes the impedance presented at the second summing junction to be mirrored to the first summing junction, improves the impedance matching at the first summing junction when the second auxiliary amplifier stage is switched off. This improved impedance matching improves the power transfer from the main amplifier stage and first auxiliary amplifier stage which improves the operating efficiency of the Doherty amplifier when the second auxiliary amplifier stage is switched off. This improvement in power transfer reduces DC consumption at lower power output levels.

The characteristic impedance of the quarter wavelength impedance transformer is derived from the impedance of the load and the impedance presented to the half wavelength line and the second auxiliary output at the second summing junction. Accordingly, the characteristic impedance of the quarter wavelength impedance transformer is selected to present an impedance to the second summing junction which matches the parallel impedances presented by the half wavelength delay line and the output of the second auxiliary amplifier stage output when in the amplifying state. This helps to ensure

that maximum power transfer occurs at the second summing junction when the amplifying stages of the Doherty amplifier are in the amplifying state.

In one embodiment, the Doherty amplifier comprises an input network comprising: an input quarter wavelength delay line coupled with an input of the first auxiliary stage; and an input half wavelength delay line coupled with an input of the second auxiliary stage through which the input signal is received. Accordingly, appropriate delay lines are coupled with the auxiliary stages of the Doherty amplifier to ensure that the amplified signals are in the correct phase to ensure that the correct summing occurs at the summing junctions.

In one embodiment, the output network comprises: a coupling quarter wavelength impedance transformer coupling the main output with the first summing junction. Accordingly, an appropriate impedance transformer is provided between the output of the main amplifier stage and the output of the first auxiliary amplifier stage in order to present a higher impedance to the output of the main amplifying stage.

In one embodiment, the characteristic impedance of the half wavelength delay matches that of the load.

In one embodiment, the Doherty comprises at least one additional auxiliary amplifier stage, each additional auxiliary amplifier stage being provided between the first summing point and the half wavelength delay line and having an additional input half wavelength delay line coupled with an input of the additional auxiliary stage through which the input signal is received and an additional half wavelength delay line coupling an additional auxiliary output with the one of the summing junctions. Accordingly, further auxiliary amplifying stages may be provided. Typically, these may be located between the first summing junction and the half wavelength delay line. Each additional auxiliary amplifier stage may be provided with an input network, which may typically comprise a half wavelength delay line, and an output network, which will typically also comprise a half wavelength delay line. It will be appreciated that this arrangement provides for a highly scalable Doherty amplifier made up of many efficient amplifying stages.

In one embodiment, a power rating of the main amplifier differs to a power rating of each auxiliary amplifier stage. Accordingly, unlike many existing Doherty amplifier arrangements, the size and/or power rating of the amplifying stages may differ. It will be appreciated that this provides for flexibility in the sourcing and manufacturing of the amplifier stages of the Doherty amplifier.

According to a second aspect, there is provided a method of configuring a Doherty amplifier as claimed in claim 7. amplifier stage having a first auxiliary output; a second auxiliary amplifier stage having a second auxiliary output; providing an output network coupling the main amplifier stage with the first amplifier stage and the second amplifier stage and operable to combine amplified signals provided by the amplifier stages to provide a load with the amplified signal, the output network comprising: a first summing junction coupled with the first auxiliary output and the main output; a half wavelength delay line coupling the second auxiliary output with the first summing junction; a second summing junction coupling the second auxiliary output with the half wavelength delay line; a quarter wavelength impedance transformer coupling the second summing junction with the load; and selecting the characteristic impedance for the quarter wavelength impedance transformer derived from the impedance of the load and the impedance presented to the half wavelength line and the second auxiliary output at the second summing junction according to the algorithm as defined in claim 7.

Further particular and preferred aspects are set out in the accompanying independent and dependent claims.

## BRIEF DESCRIPTION OF THE DRAWINGS

Embodiments of the present invention will now be described further, with reference to the accompanying drawings, in which:

Figure 1a illustrates a Doherty amplifier with all stages fully on; and

Figure 1b illustrates a Doherty amplifier with auxiliary stage 2 off.

## DESCRIPTION OF THE EMBODIMENTS

Before discussing the embodiments in any detail, an overview of the operation of a Doherty amplifier according to embodiments will now be described.

A typical Doherty amplifier comprises a main amplifying stage and one or more auxiliary amplifying stages. The number of amplifying stages that are in the amplifying state varies in dependence on the power output required from the Doherty amplifier. When less power is required to be output by the Doherty amplifier then one or more of the auxiliary amplifying stages will be switched off. When all the amplifying stages are switched on, the Doherty amplifier provides an amplified signal having a maximum output power.

Each amplifying stage amplifies the input signal in parallel and the amplified outputs of each of the amplifying stages are then combined to provide the amplified output signal. Accordingly, an input network is provided which feeds the signal to be amplified in parallel to each of the amplifying stages. Also, an output network is provided which receives each amplified output signal and combines these to provide an amplified output to a load. The input network provides the necessary phase shifts to the input signals being fed to each of the amplifier stages. Likewise, the output network provides the necessary phase shifts prior to combining the output signals provided by each of the amplifying stages.

The characteristics of the input and output networks are carefully selected not only to provide both the required phase shifts but also to provide impedance matching in order to maximise the power transfer into the load. However, a problem that occurs with existing Doherty amplifiers is that when auxiliary stages are switched off, a large mismatch can occur in the impedance presented to a summing point which receives the output from the main amplifying stage and the output of the first auxiliary stage. This impedance mismatch causes a high DC current to occur when further auxiliary amplifier stages are switched off, which can significantly reduce the efficiency of the amplifier when being driven at less than full power.

To help ameliorate this problem, an output network having a quarter wave transformer with a carefully selected characteristic impedance is provided in combination with a half wavelength delay line in order to reduce the impedance mismatch occurring at the first summing junction. The quarter wave transformer presents an optimal impedance to the second summing junction to maximise impedance matching when all amplifying states are in the amplifying state and the half-wave delay line mirrors this impedance to the first summing junction. This mirroring caused by the half-wave delay line presents an impedance at the first summing junction which more closely matches the optimal impedance required to maximise power transfer when the further auxiliary amplifier stages are switched off. This reduction in impedance mismatch helps to reduce the DC current experienced when subsequent auxiliary amplifier stages are switched off and helps to improve the efficiency of the Doherty amplifier when it is not operating in the fully on state.

ALL AMPLIFYING STAGES ON

Figure 1a shows a schematic illustration of a Doherty amplifier according to one embodiment when each of the amplifying stages are in the amplifying state.

The RF signal 10 to be amplified is received at the signal splitter 20. The signal splitter 20 divides the signal into two and outputs the RF signal 10 at points A and B. It will be appreciated that such signal splitters 20 are well known in the art. The signal from point A is provided over a line 25 to a main amplifying stage 30 and to a quarter wavelength delay line 40. The signal from point B is provided over the line 27 to a half wavelength delay line 50. A quarter wavelength delayed signal is provided over the line 45 to the first auxiliary stage 60. A half wavelength delayed signal is provided over the line 55 to the second auxiliary stage 70.

Typically, for design convenience and general interoperability, the characteristic impedance of the line over which the RF signal 10 is received, together with the characteristic impedances of the splitter 20 and the lines 25, 45, 27, 55, together with the delay lines 40 and 50, will each be 50 ohms. However, it will be appreciated that other characteristic impedances could be selected to suit the particular application.

Each of the amplifier stages 30, 60, 70 have an input impedance matching circuit and an output impedance matching circuit, together with a main amplifying device. In this example, the impedance matching circuits configure the amplifying devices to present a 50 ohms input impedance and a 50 ohms output impedance. However, once again, it will be appreciated that the impedance matching circuits may be configured to provide other input and output impedances. Also, in this example, the power rating of the main and first auxiliary stages are matched, but the power rating of the second auxiliary stage need not be matched. It will be appreciated that this provides significant flexibility to select different devices best suited to the characteristics required from the Doherty amplifier.

An amplified output signal of the main stage 30 is provided over the line 35 to the quarter wavelength transformer 80. The transformed amplified output signal from the main device 30 is received from quarter wavelength transformer 80 over the line 85 at the first summing point 150 where it is combined with an amplified output signal received from the first auxiliary stage 60 over the line 65. A combined signal is then received over the line 155 at the half wavelength delay line 90. The output from the half wavelength delay line 90 is then received over the line 95 where it is received at the second summing point 160 and combined with an amplified output from the second auxiliary stage 70 over the line 75. The combined signal from all three amplifier stages 30, 60, 70 present at the second summing point 160 is provided via the quarter wave transformer 100 to the load 110.

An explanation will now be given of the impedances at different points in the output network. The 50 ohm load 110 has its impedance transformed by the quarter wave transformer 100 which then presents an impedance over the line 165 of 16.7 ohms to the second summing point 160. This impedance matches the parallel impedance presented by the second auxiliary stage 70 and the half wavelength delay line 90 to the second summing point 160. This is because 16.7 ohms matches the impedance of 50 ohms presented by the second auxiliary stage 70 in parallel with 25 ohms presented by the half wavelength delay line 90. Accordingly, maximum power transfer occurs at the second summing point 160.

Likewise, because the half wavelength delay line 90 performs no impedance transformation, the impedance presented by the half wavelength delay line 90 over the line 155 to the first summing point 150 is also 25 ohms, which matches the parallel impedance provided by the quarter wave transformer 80 in parallel with the first auxiliary stage 60. In particular, the 25 ohm impedance presented on the line 155 matches the impedance of 50 ohms presented by the first auxiliary stage 60 in parallel with the impedance of 50 ohms presented by the quarter wavelength transformer 80. Accordingly, full power transfer also occurs at the first summing point 150.

Hence, when the amplified stages 30, 60, 70 are fully on, impedance matching occurs at the summing

junctions 150, 160 which maximises the performance of the amplifier and minimises any DC currents.

SECOND AUXILIARY STAGE OFF

Consider now the situation where the second auxiliary stage 70 is switched off. In this situation, the impedance presented over the line 75 will effectively be infinite, which means that the impedance presented to the second summing point 160 over the line 165 will be 16.7 ohms, as before.

This impedance is then replicated by the half wavelength line 90, which causes an impedance of 16.7 ohms to be presented to the first summing point 150 over the path 155. Although the impedance presented to the first summing point 150 by the first auxiliary stage 60 in parallel with the quarter wave transformer 80 is still 50 ohms in parallel with 50 ohms (i.e. 25 ohms), there is only a small mismatch in impedance between 25 ohms and 16.7 ohms. Accordingly, through the provision of the quarter wave transformer 100 and the half wavelength line 90, the impedance mismatch at the first summing point 150 when the second auxiliary stage 70 is non-amplifying is reduced, which improves the performance of the Doherty amplifier when the additional auxiliary stages are non-amplifying and therefore reduces the DC current consumed in those states.

To enable the correct impedance to be presented by the quarter wave transformer 100, its characteristic impedance needs to be carefully selected. In this example, the quarter wave transformer 100 needs to present 16.7 ohms from a 50 ohm load. The following equation describes the characteristic impedance, Zt:

$$Zt = \sqrt{Zl \times \frac{1}{1/Za2 + 1/Zh}}$$

where Zl is the impedance of the load 110, Za2 is the impedance presented by the half wavelength delay line 90 at the second summing point 160 and Zh is the impedance presented by the second auxiliary stage at the second summing point 160, i.e:

$$29 = \sqrt{50 \times \frac{1}{1/25 + 1/50}}$$

Accordingly, it can be seen that the architecture mentioned above enables a multi- way Doherty amplifier to be provided whilst addressing the complexity of designing the output combining network. Unlike previous techniques, there is no need to use a symmetrical approach whereby three identically- sized devices are required, which limits the flexibility of design and loses gain as a result of the split of the input signal. Also, this approach avoids the need for the main amplifier stage 30 to perform a 4: 1 impedance transformation ratio with the first auxiliary stage 60 performing a 2: 1 transformation ratio to achieve a three- way Doherty operation. In that approach, when reduced output power is required, the second auxiliary stage 70 would need to be turned off and only the main amplifier stage 30 and first auxiliary stage 60 would be in operation. When under those operating conditions, due to the 2: 1 transformation setup, the output power at the load 110 does not reflect the full output power capability of the main amplifier stage 30 and first auxiliary stage 60.

In contrast, a 1:1 ratio may be employed on the main amplifier stage 30 and first auxiliary stage 60. The size of the second auxiliary stage 70 can be of any value, although it will be generally 2:1. With this arrangement, at full power, the second summing point 160 will have a combined RF impedance of 25 ohms. This gets transformed to 50 ohms via the quarter wave transformer 100. At the first summing point 150, the combined RF impedance is also 25 ohms and does not get transformed but is presented with a 180° 25 ohm delay line instead. Under low power (i.e. when the second auxiliary stage 70 is off) the full power of the main amplifier stage 30 and the first auxiliary stage 60 at the first summing point 150 are appropriately transferred to the second summing point 160 before an impedance transformation to 50 ohms. At the input, the 180° delay becomes effective by presenting an RF open at point B of the splitter 20. Thus, a simple non-resistive 50 ohm micro splitter 20 can be used, such that point A does not see a 3dB reduction in RF input drive. Thus, there is already an immediate advantage in gain performance under reduced power output levels. This enables device sizes to be easily selected for full performance and cost optimization and enables the design of a complex multi-way Doherty to be simplified.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of

executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to be limited only by the scope of the appended claims.

## Claims

**1.** A Doherty amplifier (200) comprising:

a plurality of amplifier stages (30, 60, 70), each amplifier stage being operable to receive an input signal (10) to be amplified, each amplifier stage being switchable between an amplifying state and a non-amplifying state to vary a power of an amplified signal provided by said Doherty amplifier, said plurality of amplifier stages comprising:

a main amplifier stage (30) having a main output (35);
a first auxiliary amplifier stage (60) having a first auxiliary output (65);
a second auxiliary amplifier stage (70) having a second auxiliary output (75); and
an output network coupling said main amplifier stage with said first auxiliary amplifier stage and said second auxiliary amplifier stage and operable to combine amplified signals provided by said amplifier stages to provide a load (110) with said amplified signal, said output network comprising:

a first summing junction (150) coupled with said first auxiliary output and said main output;
a half wavelength delay line (90) coupling said second auxiliary output with said first summing junction to perform no impedance transformation;
a second summing junction (160) coupling said second auxiliary output with said half wavelength delay line;
a quarter wavelength impedance transformer (100) coupling said second summing junction with said load, wherein the characteristic impedance of said quarter wavelength impedance transformer is configured to be selected in accordance with the following algorithm:

$$\sqrt{Zl \times \frac{1}{1/_{Za2} + 1/_{Zh}}}$$

where Zl is the impedance of said load, Za2 is the impedance presented by said half wavelength delay line (90) at said second summing junction and Zh is the impedance presented by said second auxiliary amplifier stage (70) at said second summing junction.

**2.** The Doherty amplifier of any preceding claim, comprising an input network comprising:

an input quarter wavelength delay line (40) coupled with an input of said first auxiliary stage; and
an input half wavelength delay line (50) coupled

with an input of said second auxiliary stage through which said input signal is received.

**3.** The Doherty amplifier of any preceding claim, wherein said output network comprises:

a coupling quarter wavelength impedance transformer (80) coupling said main output with said first summing junction.

**4.** The Doherty amplifier of any preceding claim, wherein said characteristic impedance of said half wavelength delay matches that of said load.

**5.** The Doherty amplifier of any preceding claim, comprising at least one additional auxiliary amplifier stage, each additional auxiliary amplifier stage being provided between said first summing point and said half wavelength delay line and having an additional input half wavelength delay line coupled with an input of said additional auxiliary stage through which said input signal is received and an additional half wavelength delay line coupling an additional auxiliary output with said one of said summing junctions.

**6.** The Doherty amplifier of any preceding claim wherein a power rating of said main amplifier differs to a power rating of each auxiliary amplifier stage.

**7.** A method of configuring a Doherty amplifier (200) comprising the steps of:

providing a plurality of amplifier stages (30, 60, 70), each amplifier stage being operable to receive an input signal (10) to be amplified, each amplifier stage being switchable between an amplifying state and a non-amplifying state to vary a power of an amplified signal provided by said Doherty amplifier, said plurality of amplifier stages comprising: a main amplifier stage (30) having a main output (35); a first auxiliary amplifier stage (60) having a first auxiliary output (65); a second auxiliary amplifier stage (70) having a second auxiliary output (75);
providing an output network coupling said main amplifier stage with said first auxiliary amplifier stage and said second auxiliary amplifier stage and operable to combine amplified signals provided by said amplifier stages to provide a load (110) with said amplified signal, said output network comprising: a first summing junction (150) coupled with said first auxiliary ouput and said main output; a half wavelength delay line (90) coupling said second auxiliary output with said first summing junction (160) to perform no impedance transformation; a second summing junction coupling said second auxiliary output with said half wavelength delay line; a quarter wavelength impedance transformer (100) coupling said second summing junction with said load; and
selecting a characteristic impedance for said quarter wavelength impedance in accordance with the following algorithm:

$$\sqrt{Zl \times \frac{1}{1/_{Za2} + 1/_{Zh}}}$$

where Zl is the impedance of said load, Za2 is the impedance presented by said half wavelength delay line (90) at said second summing junction and Zh is the impedance presented by said second auxiliary amplifier stage (70) at said second summing junction.

## Patentansprüche

**1.** Doherty-Verstärker (200), umfassend:

Eine Vielzahl von Verstärkerstufen (30, 60, 70), wobei jede Verstärkerstufe für den Empfang eines zu verstärkenden Eingangssignals (10) betreibbar ist, wobei jede Verstärkerstufe zwischen einem Verstärkungszustand und einem Nicht-Verstärkungszustand schaltbar ist, um eine Leistung eines von dem besagten Doherty-Verstärkers bereitgestellten verstärkten Signals zu ändern, wobei die besagte Vielzahl von Verstärkerstufen umfasst:

eine Hauptverstärkerstufe (30) mit einem Hauptausgang (65);
eine erste Hilfsverstärkerstufe (60) mit einem ersten Hilfsausgang (65);
eine zweite Hilfsverstärkerstufe (70) mit einem zweiten Hilfsausgang (75); und
ein Ausgangsnetzwerk, welches die besagte Hauptverstärkerstufe mit der besagten ersten Hilfsverstärkerstufe und der besagten zweiten Hilfsverstärkerstufe koppelt und betreibbar ist, um von den besagten Verstärkerstufen bereitgestellte verstärkte Signale zu kombinieren, um eine Last (110) mit dem besagten verstärkten Signal bereitzustellen, wobei das besagte Ausgangsnetzwerk umfasst:

einen ersten Summationspunkt (150), welcher mit dem besagten ersten Hilfsausgang und dem besagten Hauptausgang gekoppelt ist;

eine Halbwellenlängen-Verzögerungsleitung (90), welche den besagten zweiten Hilfsausgang mit dem besagten ersten Summationspunkt koppelt, so dass keine Impedanztransformation erfolgt;
einen zweiten Summationspunkt (160), welcher den besagten zweiten Hilfsausgang mit der besagten Halbwellenlängen-Verzögerungsleitung koppelt;
einen Viertelwellenlängen-Impedanzwandler (100), welcher den besagten zweiten Summationspunkt mit der besagten Last koppelt, wobei die charakteristische Impedanz des besagten Viertelwellenlängen-Impedanzwandlers die durch

$$\sqrt{Zl \times \frac{1}{1/Za2 + 1/Zh}}$$

dargestellte Impedanz ist,
wobei Zl die Impedanz der besagten Last ist, Za2 die durch die besagte Halbwellenlängen-Verzögerungsleitung (90) an dem besagten zweiten Summationspunkt ist, und Zh die von der besagten zweiten Hilfsverstärkerstufe dargestellte Impedanz an dem besagten zweiten Summationspunkt ist.

**2.** Doherty-Verstärker nach einem beliebigen der vorstehenden Ansprüche, umfassend ein Eingangsnetzwerk mit:

einer Viertelwellenlängen-Eingangsverzögerungsleitung (40), welche mit einem Eingang der besagten ersten Hilfsstufe gekoppelt ist; und
einer Halbwellenlängen-Eingangsverzögerungsleitung (50), welche mit einem Eingang der besagten zweiten Hilfsstufe, über welchen das besagte Eingangssignal empfangen wird, gekoppelt ist.

**3.** Doherty-Verstärker nach einem beliebigen der vorstehenden Ansprüche, wobei das besagte Ausgangsnetzwerk umfasst:

Einen Viertelwellenlängen-Koppelimpedanzwandler (80), welcher den besagten Hauptausgang mit dem besagten ersten Summationspunkt koppelt.

**4.** Doherty-Verstärker nach einem beliebigen der vorstehenden Ansprüche, wobei die besagte charakteristische Impedanz der besagten Halbwellenlängen-Verzögerung der Impedanz der besagten Last entspricht.

**5.** Doherty-Verstärker nach einem beliebigen der vorstehenden Ansprüche, umfassend mindestens eine zusätzliche Hilfsverstärkerstufe, wobei jede zusätzliche Hilfsverstärkerstufe zwischen dem besagten ersten Summationspunkt und der besagten Halbwellenlängen-Verzögerungsleitung angeordnet ist und eine zusätzliche Halbwellenlängen-Eingangsverzögerungsleitung, welche mit einem Eingang der besagten zusätzlichen Hilfsstufe, über welchen das besagte Eingangssignal empfangen wird, gekoppelt ist, und eine zusätzliche Halbwellenlängen-Verzögerungsleitung, welche einen zusätzlichen Hilfsausgang mit dem besagten einen der besagten Summationspunkte koppelt, aufweist.

**6.** Doherty-Verstärker nach einem beliebigen der vorstehenden Ansprüche, wobei eine Nennleistung des besagten Hauptverstärkers von einer Nennleistung einer jeden Hilfsverstärkerstufe abweicht.

**7.** Verfahren zum Konfigurieren eines Doherty-Verstärkers (200), die folgenden Schritte umfassend:

Bereitstellen einer Vielzahl von Verstärkerstufen (30, 60, 70), wobei jede Verstärkerstufe für den Empfang eines zu verstärkenden Eingangssignals (10) betreibbar ist, wobei jede Verstärkerstufe zwischen einem Verstärkungszustand und einem Nicht-Verstärkungszustand schaltbar ist, um eine Leistung eines von dem besagten Doherty-Verstärkers bereitgestellten verstärkten Signals zu ändern, wobei die besagte Vielzahl von Verstärkerstufen umfasst: eine Hauptverstärkerstufe (30) mit einem Hauptausgang (35); eine erste Hilfsverstärkerstufe (60) mit einem ersten Hilfsausgang (65); eine zweite Hilfsverstärkerstufe (70) mit einem zweiten Hilfsausgang (75);
Bereitstellen eines Ausgangsnetzwerks, welches die besagte Hauptverstärkerstufe mit der besagten ersten Hilfsverstärkerstufe und der besagten zweiten Hilfsverstärkerstufe koppelt und betreibbar ist, um von den besagten Verstärkerstufen bereitgestellte verstärkte Signale zu kombinieren, um eine Last (110) mit dem besagten verstärkten Signal bereitzustellen, wobei das besagte Ausgangsnetzwerk umfasst: einen ersten Summationspunkt (150), welcher mit dem besagten ersten Hilfsausgang und dem besagten Hauptausgang gekoppelt ist; eine Halbwellenlängen-Verzögerungsleitung (90), welche den besagten zweiten Hilfsausgang mit

dem besagten ersten Summationspunkt (160) koppelt, so dass keine Impedanztransformation erfolgt; einen zweiten Summationspunkt, welcher den besagten zweiten Hilfsausgang mit der besagten Halbwellenlängen-Verzögerungsleitung koppelt; einen Viertelwellenlängen-Impedanzwandler (100), welcher den besagten zweiten Summationspunkt mit der besagten Last koppelt; und

Auswählen einer charakteristischen Impedanz für die besagte Viertelwellenlängen-Impedanz gemäß dem folgenden Algorithmus:

$$\sqrt{Zl \times \frac{1}{1/Za2 + 1/Zh}}$$

wobei Zl die Impedanz der besagten Last ist, Za2 die durch die besagte Halbwellenlängen-Verzögerungsleitung (90) an dem besagten zweiten Summationspunkt ist, und Zh die von der besagten zweiten Hilfsverstärkerstufe dargestellte Impedanz an dem besagten zweiten Summationspunkt ist.

## Revendications

**1.** Amplificateur de Doherty (200) comprenant :

une pluralité d'étages d'amplificateur (30, 60, 70), chaque étage d'amplificateur permettant de recevoir un signal d'entrée (10) à amplifier, chaque étage d'amplificateur pouvant passer d'un état d'amplification à un état de non-amplification pour modifier une puissance d'un signal amplifié fourni par ledit amplificateur de Doherty, ladite pluralité d'étages d'amplificateur comprenant :

un étage d'amplificateur principal (30) présentant une sortie principale (35) ;
un premier étage d'amplificateur auxiliaire (60) présentant une première sortie auxiliaire (65) ;
un deuxième étage d'amplificateur auxiliaire (70) présentant une deuxième sortie auxiliaire (75) ;
et
un réseau de sortie couplant ledit étage d'amplificateur principal audit premier étage d'amplificateur auxiliaire et audit deuxième étage d'amplificateur auxiliaire et permettant de combiner des signaux amplifiés fournis par lesdits étages d'amplificateur pour fournir une charge (110) audit signal amplifié, ledit réseau de sortie comprenant :

une première jonction de sommation (150) couplée à ladite première sortie auxiliaire et à ladite sortie principale ;
une ligne à retard de demi-longueur d'onde (90) couplant ladite deuxième sortie auxiliaire à ladite première jonction de sommation pour effectuer une transformation sans impédance ;
une deuxième jonction de sommation (160) couplant ladite deuxième sortie auxiliaire à ladite ligne à retard de demi-longueur d'onde ;
un transformateur d'impédance de quart de longueur d'onde (100) couplant ladite deuxième jonction de sommation à ladite charge, dans lequel l'impédance caractéristique dudit transformateur d'impédance de quart de longueur d'onde est l'impédance présentée par :

$$\sqrt{Zl \times \frac{1}{1/Za2 + 1/Zh}}$$

où Zl est l'impédance de ladite charge, Za2 est l'impédance présentée par ladite ligne à retard de demi-longueur d'onde (90) au niveau de ladite deuxième jonction de sommation et Zh est l'impédance présentée par ledit deuxième étage d'amplificateur auxiliaire (70) au niveau de ladite deuxième jonction de sommation.

**2.** Amplificateur de Doherty selon l'une quelconque des revendications précédentes, comprenant un réseau d'entrée comprenant :

une ligne à retard de quart de longueur d'onde d'entrée (40) couplée à une entrée dudit premier étage auxiliaire ; et
une ligne à retard de demi-longueur d'onde d'entrée (50) couplée à une entrée dudit deuxième étage auxiliaire à travers laquelle ledit signal d'entrée est reçu.

**3.** Amplificateur de Doherty selon l'une quelconque des revendications précédentes, dans lequel ledit réseau de sortie comprend :

un transformateur d'impédance de quart de longueur d'onde de couplage (80) couplant ladite sortie principale à ladite première jonction de sommation.

4. Amplificateur de Doherty selon l'une quelconque des revendications précédentes, dans lequel ladite impédance caractéristique dudit retard de demi-longueur d'onde correspond à celle de ladite charge.

5. Amplificateur de Doherty selon l'une quelconque des revendications précédentes, comprenant au moins un étage d'amplificateur auxiliaire supplémentaire, chaque étage d'amplificateur auxiliaire supplémentaire étant fourni entre ledit premier point de sommation et ladite ligne à retard de demi-longueur d'onde et présentant une ligne à retard de demi-longueur d'onde d'entrée supplémentaire couplée à une entrée dudit étage auxiliaire supplémentaire à travers laquelle ledit signal d'entrée est reçu et une ligne à retard de demi-longueur d'onde supplémentaire couplant une sortie auxiliaire supplémentaire à ladite jonction parmi lesdites jonctions de sommation.

6. Amplificateur de Doherty selon l'une quelconque des revendications précédentes dans lequel une puissance nominale dudit amplificateur principal est différente d'une puissance nominale de chaque étage d'amplificateur auxiliaire.

7. Procédé de configuration d'un amplificateur de Doherty (200) comprenant les étapes suivantes :

fournir une pluralité d'étages d'amplificateur (30, 60, 70), chaque étage d'amplificateur permettant de recevoir un signal d'entrée (10) à amplifier, chaque étage d'amplificateur pouvant passer d'un état d'amplification à un état de non-amplification pour modifier une puissance d'un signal amplifié fourni par ledit amplificateur de Doherty, ladite pluralité d'étages d'amplificateur comprenant : un étage d'amplificateur principal (30) présentant une sortie principale (35) ; un premier étage d'amplificateur auxiliaire (60) présentant une première sortie auxiliaire (65) ; un deuxième étage d'amplificateur auxiliaire (70) présentant une deuxième sortie auxiliaire (75) ; fournir un réseau de sortie couplant ledit étage d'amplificateur principal audit premier étage d'amplificateur auxiliaire et audit deuxième étage d'amplificateur auxiliaire et permettant de combiner des signaux amplifiés fournis par lesdits étages d'amplificateur pour fournir une charge (110) audit signal amplifié, ledit réseau de sortie comprenant:

une première jonction de sommation (150) couplée à ladite première sortie auxiliaire et à ladite sortie principale ; une ligne à retard de demi-longueur d'onde (90) couplant ladite deuxième sortie auxiliaire à ladite première jonction de sommation (160) pour effectuer une transformation sans impédance ; une deuxième jonction de sommation couplant ladite deuxième sortie auxiliaire à ladite ligne à retard de demi-longueur d'onde ; un transformateur d'impédance de quart de longueur d'onde (100) couplant ladite deuxième jonction de sommation à ladite charge ; et

sélectionner une impédance caractéristique pour ladite impédance de quart de longueur d'onde conformément à l'algorithme suivant :

$$\sqrt{Zl \times \frac{1}{1/Za2 + 1/Zh}}$$

où Zl est l'impédance de ladite charge, Za2 est l'impédance présentée par ladite ligne à retard de demi-longueur d'onde (90) au niveau de ladite deuxième jonction de sommation et Zh est l'impédance présentée par ledit deuxième étage d'amplificateur auxiliaire (70) au niveau de ladite deuxième jonction de sommation.

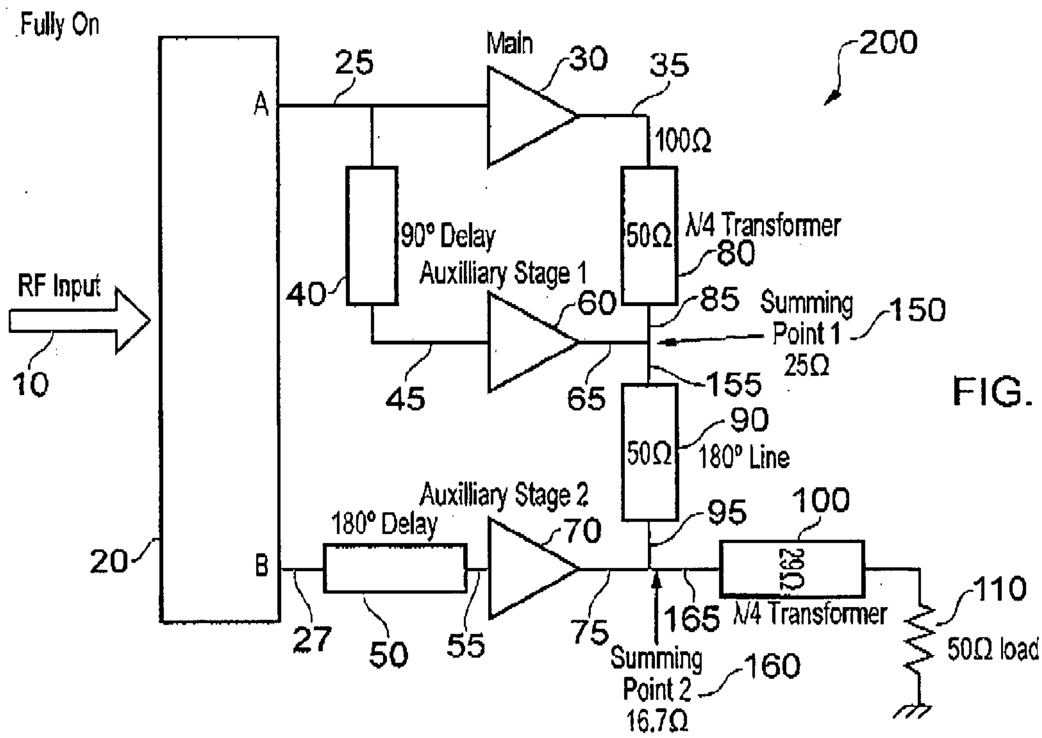
Fully On
RF Input
10
20
A
B
25
27
Main
30
35
100Ω
50Ω
λ/4 Transformer
80
90° Delay
40
Auxilliary Stage 1
60
45
65
85
Summing Point 1 25Ω
150
155
50Ω
90
180° Line
Auxilliary Stage 2
70
180° Delay
50
55
75
95
100
29Ω
λ/4 Transformer
165
Summing Point 2 16.7Ω
160
110
50Ω load
200

FIG. 1A

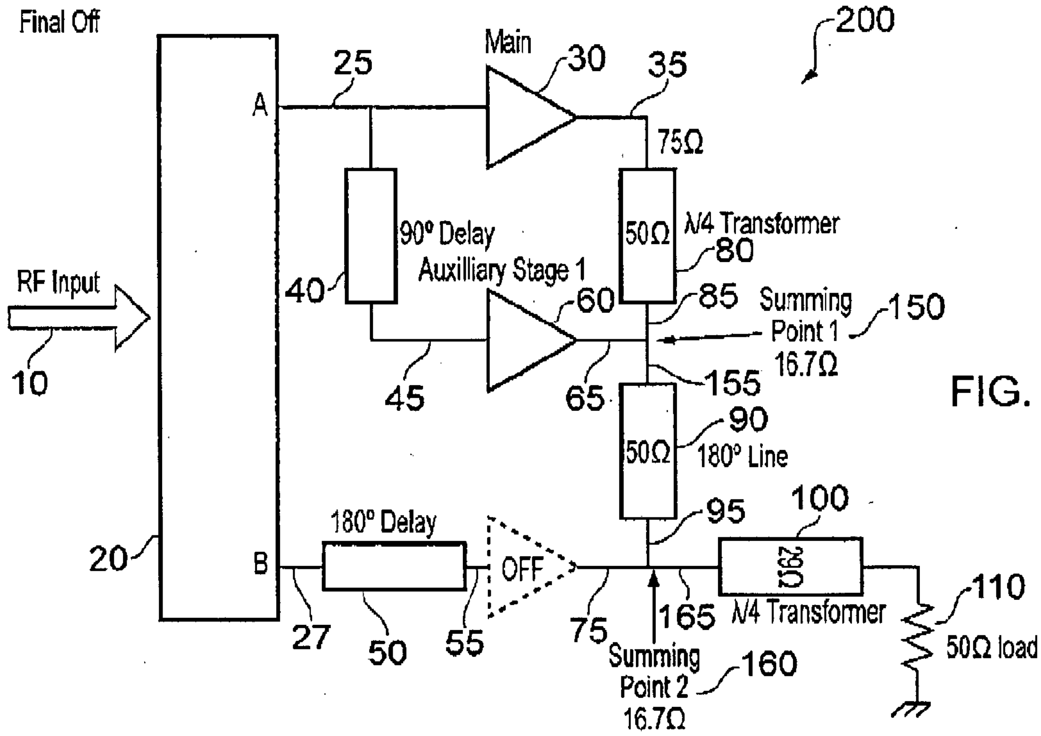
Final Off
RF Input
10
20
A
B
25
27
Main
30
35
75Ω
50Ω
λ/4 Transformer
80
90° Delay
40
Auxilliary Stage 1
60
45
65
85
Summing Point 1 16.7Ω
150
155
50Ω
90
180° Line
180° Delay
50
55
OFF
75
95
100
29Ω
λ/4 Transformer
165
Summing Point 2 16.7Ω
160
110
50Ω load
200

FIG. 1B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0195481 A1